# EUROPEAN PATENT APPLICATION

(11) **EP 1 195 645 A1**
(43) Date of publication of application: **10.04.2002**
(21) Application number: 01306785.5
(22) Date of filing: 08.08.2001
(51) Int. Cl.: G03F 1/00

(54) **Protective layers for photocurable elements**

(30) Priority: 03.10.2000 US 678540
(71) Applicant: MacDermid Graphic Arts, Atlanta, Georgia 30336-2293 (US)
(72) Inventor: Tsao, Jung-Hsien, Marietta, Georgia 30062 (US); Yu, Chen-Hsum, Marietta, Georgia 30068 (US); Cook, Brian, Atlanta, Georgia 30339 (US); Rosen, Daniel, Acworth, Georgia 30102 (US)
(74) Representative: Price, Nigel John King

(57) **Abstract**

Printing elements are prepared by depositing a negative-forming ink onto a first face of a photocurable element having first and second opposing major faces, wherein: (1) the ink is being substantially opaque to actinic radiation in at least one wavelength region effective to cure photocurable material within the element and substantially resistant to polymerization upon exposure to actinic radiation in the wavelength. region; and (2) the first face of the photocurable element includes a protective layer that is substantially impermeable with respect to the ink.

## Description

The present invention is directed to the direct transfer of images to photocurable elements by, for example, depositing ink on a layer of photocurable material and, more particularly, to the use of protective layers between the ink and the photocurable material.

Relief image printing plates are used in both flexographic and letterpress processes for printing on a variety of substrates, including paper, corrugated stock, film, foil, and laminates. The photocurable elements that are used to make relief plates can inelude a support layer one or more layers of photocurable polymer in the form of solid sheets, and a protective slip-film on top of the photocurable polymer. The printer typically peels a cover sheet from the element and places a silver halide photographic negative or some other masking device upon the exposed surface. The negative-bearing photocurable element then is exposed to ultraviolet (UV) light through the negative, thereby causing exposed areas of the element to harden, or cure. After the uncured areas of the element are removed, cured polymer remains as the relief printing surface.

Alternatively, one can create a negative image on a photocurable element by depositing a desired pattern of ink or some other sufficiently opaque material upon the exposed surface of the element following removal of the cover sheet (*see, e.g*., U.S. Patent No. 5,846,691). The ink-bearing element then is exposed to UV light, thereby causing exposed areas of the element to harden, or cure. There typically is a variable -- and, often, unavoidably long -- time interval between these deposition and exposure steps, and Applicants have observed that the quality of the printing plate that ultimately is produced varies inversely with this interval. That is, the functional properties of printing plates that are produced when this interval is relatively small (such as, for example, ability to image and print finer details or small characters) are better than the functional properties of printing plates that are produced when this interval is relatively large.

Consequently, there is a need in the art for some means for producing printing plates of high quality, even in those instances in which an ink or some other opaque material remains on the surface of a photocurable element for a relatively long period of time.

The present invention provides methods for preparing photocurable elements comprising the step of depositing a negative-forming ink onto a first face of a photocurable element having first and second opposing major faces, the ink being substantially opaque to actinic radiation in at least one wavelength region effective to cure photocurable material within the element and substantially resistant to polymerization upon exposure to actinic radiation in the wavelength region. In certain embodiments of the invention, the first face of the photocurable element includes a protective layer that is substantially impermeable with respect to the ink. Preferred protective layers are those composing hydrophilic polymers such as, for example, polyvinyl alcohols, film-forming starch derivatives, film-forming cellulose derivatives, copolymers of acrylic acid with other vinyl monomer, and mixtures thereof. Particularly preferred protective layers are those comprising film-forming cellulose derivatives such as, for example, cellulose ethers, such as, for example, carboxymethyl cellulose (CMC), methylcellulose (MC), hydroxyethyl cellulose (HEC), hydroxypropyl cellulose (HPC), and hydroxypropyl methylcellulose (HPMC).

The present invention also provides photocurable elements which, in preferred embodiments comprise a support layer, photocurable material disposed upon the support layer, and a protective layer of the invention disposed upon the photocurable material.

The numerous objects and advantages of the present invention may be better understood by those skilled in the art by reference to the accompanying non-scale figures, in which:

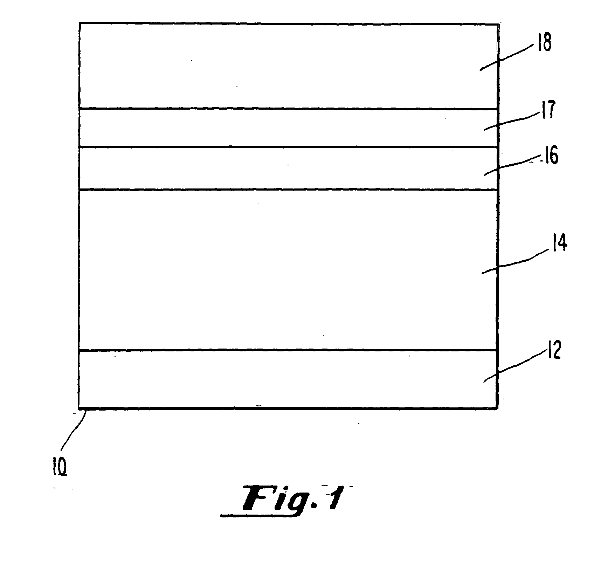

Figure 1 is a cross-sectional view of a photocurable element according to the invention.

There are a wide variety of photocurable elements that can be used in accordance with the invention. The photocurable elements can be solid or can include one or more liquid components. In preferred embodiments, the elements vary in thickness from about 0.025 inches to about 0.25 inches and have dimensions up to about 52 inches to about 80 inches. Solid photocurable elements can exist as cylinders or rectilinear sheets. As shown in Figure 1, a preferred photocurable element **10** comprises a support layer **12,** one or more photocurable layers **14, 16** and a removable cover sheet **18.** Photocurable elements of the present invention comprise a transparent protective layer **17** disposed between the cover sheet and the photocurable layer(s).

The support, or backing, layer **12** can be formed from a transparent or opaque material such as paper, cellulose film, plastic, or metal. In preferred embodiments, it is a polyethylene terephthalate film having a thickness on the order of 0.005 inches. The support optionally bears an adhesive for more secure attachment to the photocurable layer.

The photocurable layer, which generally has a thickness of from about 0.02 to 0.245 inches, can include a variety of known photopolymers, initiators, reactive diluents, filler, and dyes. Preferred photocurable materials include an elastomer compound, an ethylenically unsaturated compound having at least one terminal ethylenic group, and a photoinitiator. Exemplary photocurable materials are disclosed in European Patent Applications 0 456 336 A2 (Goss, *et al*.) and 0 640 878 A1 (Goss, *et al*.), British Patent No 1,366,769, and U.S. Patent Nos. 5,223,375 (Berrier, *et al*.), 3,867,153 (MacLahan), 4,264,705 (Allen), 4,265,986 (Allen), 4,323,636 (Chen, *et al*.), 4,323,637 (Chen, *et al*.), 4,369,246 (Chen, *et al*.), 4,423,135 (Chen, *et al*.), and 3,265,765 (Holden, *et al*.), 4,320,188 (Heinz, *et al*.), 4,427,759 (Gruetzmacher, *et al*.), 4,460,675 (Gruetzmacher, *et al*.), 4,622,088 (Min), and 5,135,827 (Bohm, *et al*.), which are incorporated herein by reference. If a second photocurable layer is used, it typically is disposed upon the first and is similar in composition but considerably thinner, usually less than 0.01 inches.

The photocurable materials of the invention should cross-link (cure) and, thereby, harden in at least some actinic wavelength region. As used herein, actinic radiation is radiation capable of effecting a chemical change in an exposed moiety. Actinic radiation includes, for example, amplified (*e.g.,* laser) and non-amplified light, particularly in the UV and infrared wavelength regions. Preferred actinic wavelength regions are from about 250 nm to about 450 nm, more preferably from about 300 nm to about 400 nm, even more preferably from about 320 nm to about 380 nm.

The protective layer **17** of the photocurable element, sometimes referred to as the slip film, is disposed upon the photocurable layer(s) and typically is from about 0.0001 to about 0.001 inches thick. The protective layer protects the photocurable element from contamination, increases ease of handling, and acts as an ink jet ink mask-accepting layer. The protective layer preferably is substantially impermeable with respect to the ink used. Substantially impermeable protective layers according to the invention are those which, by virtue of their thickness and/or chemical composition, prevent permeation by the ink for at least 30 minutes, preferably at least 120 minutes, even more preferably at least 24 hours. Preferred protective layers are hydrophilic, *i.e*., they absorb water but not hydrocarbon solvents such as, for example, hexane. Preferred hydrophillic layers are those comprising hydrophilic polymers such as, for example, polyvinyl alcohols, film-forming cellulose derivatives, copolymers of acrylic acid with other vinyl monomer, and mixtures thereof. Particularly preferred hydrophillic layers are those comprising film-forming cellulose derivatives such as, for example, cellulose ethers, such as, for example, carboxymethyl cellulose (CMC), methylcellulose (MC), hydroxyethyl cellulose (HEC), hydroxypropyl cellulose (HPC), and hydroxypropyl methylcellulose (HPMC). Especially preferred hydrophilic layers comprise Klucel® L hydroxypropylcellulose, which is commercially available from Hercules Inc., Wilmington, Delaware.

While not wishing to be bound to any particular theory, it is believed that one function of the protective layers of the invention is to prevent UV-absorbing compounds in the ink from contacting photocurable material in the photocurable element. Such UV-absorbing compounds are believed to interfere or interact with the photocurable material, thus preventing or inhibiting photocuring. The resulting photocured plate exhibits deterioration, which is manifested in the loss of fine dots and small graphics on the finished printing plate.

The cover sheet **18**, if present, can be formed from plastic or any other removable material that can protect the plate from damage until ready for use.

The advantages of the photocurable elements of the invention are probably best demonstrated in the context of processes for preparing composite printing plates in which photocurable elements of appropriate sizes are mounted on a carrier sheet in approximate register with the areas ultimately to be printed and precise "registration" of the elements then is achieved by application of a computer-generated negative image to the composite plate via an ink jet printer (*See, e.g.,* U.S. Patent No. 5,846,691 and U.S. Patent Application Serial No. 08/957,165 filed October 24, 1997, both incorporated herein by reference). Such composite plates preferably are prepared by first transferring computer-generated registration information to one side of a suitable carrier sheet. Precise registration preferably is achieved for composite plates by the computer-controlled transfer of a negative image directly to the outwardly-facing surfaces of at least one photocurable elements that have been mounted on the carrier sheet. Such negative images preferably are transferred by using an ink-jet printer to deposit a radiation-blocking ink on the photocurable elements' respective surfaces.

A wide variety of printers can be used in accordance with the present invention. Suitable printers are those that can print (or be adapted to print) well-defined images on various sizes and shapes of composite plates used in the printing industry. The level of definition (resolution) -- typically measured in dots per inch (dpi) -- should be as great as possible. The amount of ink delivered by the printers of the invention should be sufficient to absorb at least about 85% of any incident actinic radiation, preferably about 90% of such radiation, more preferably about 95%, and even more preferably 99.9% of such radiation. Preferred printers are those that are able to deliver a fully radiation-absorptive amount of ink in a single printing, although with some printers (and with some inks) multiple printings may be necessary to deliver a radiation-absorptive amount.

Ink jet printers are particularly preferred. Ink jet printing is performed by discharging ink droplets from a print head to a substrate. The droplets typically are ejected through orifices or nozzles in the print head and are directed to the substrate to form an image thereon. In contrast to many other types of printing, there usually is no contact between the printer and the substrate with ink jet printing. Virtually any ink jet printer can be used in accordance with the present invention, so long as it has both a print head and some means for controlling and/or directing the ejection of ink therefrom. Similarly, virtually any print head known in the art can be employed, so long as it comprises at least one nozzle which ejects ink droplets in response to control signals. Representative ink jet printers include those manufactured by Spectra Incorporated, Dataproducts Corporation (Woodland Hills, CA), Jarfalla (Sweden), Encad (San Diego, CA), AlphaMerics (Simi Valley, CA), Videojet (Wood Dale, IL), particularly the Epson Stylus (Epson Corporation, Torrance, CA), HP 600c, HP 650c, HP 855c, and HP 750c ink jet printers (Hewlett-Packard Corp., Palo Alto, CA) and the Raster Image Processor (Alan Graphics, Peekskill, NY). A particularly preferred printing apparatus is the BOXCOR™ system, which is commercially available from MacDermid Graphic Arts, Atlanta, GA.

An ink according to present invention is any liquid or solid moiety that is both substantially opaque to actinic radiation in at least one wavelength region effective to cure the above-described photocurable elements and substantially resistant to polymerization upon exposure to actinic radiation in that wavelength region. Substantially opaque inks are those that can absorb at least about 85% of any incident actinic radiation, preferably about 90% of such radiation, more preferably about 95%, and even more preferably 99.9% of such radiation. It will be recognized that a substantially opaque ink need not be substantially opaque in all amounts and at all possible concentrations, so long as it can be deposited upon a substrate in sufficient quantity so as to be substantially opaque. Inks are substantially resistant to polymerization in accordance with the invention so long as they can be removed from the surface of plates to which they are applied (preferably using conventional plate-washing techniques) without damaging the relief surface, and so long as they do not react with or otherwise alter the chemical and/or physical properties of the plate to such an extent that their removal damages the relief surface. Many such inks include one or more radiation-absorptive molecules dissolved in solvent at, for example, concentrations of about 3 to about 20 weight percent, including the U-26, U-53M, Black 4D, and Jolt brands (Dataproducts Corporation) and those formed by mixing Crown Super Marking Stamping Ink (Fulton Marking Equipment Company, Warminster, PA) and UVINUL 3050 brand 2,2',4,4'-tetrahydroxybenzophenone (BASF, Ludwigshaven, Germany) in a solvent selected from methanol, isopropanol, n-butanol, chloroform, methyl ethyl ketone, propylene glycol monomethyl ether, dipropylene glycol monomethyl ether, diethylene glycol ethyl ether, and mixtures thereof. Other common ink ingredients include the Tinopal SPF and Joncryl 68 products, which are commercially available from Ciba-Geigy Corp., Hawthorn, NY, and S.C. Johnson Company, Milwaukee, WI, respectively.

The methods of the invention involve the transfer of a negative image to the surface one or more mounted photocurable elements, typically by removing a cover sheet from elements and then printing the negative image with ink on the surfaces exposed by removal of the cover sheet. After the negative image has been transferred, it (and, hence, at least a portion of the composite plate) is exposed to actinic radiation, preferably UV light, in a suitable wavelength region. One advantage of the present invention is that one can now allow the ink-bearing plate to stand without further processing for longer periods of time without consequent deterioration of the resulting printing plate. There are many devices that can be used to expose the negative-bearing element to actinic radiation, including FLEX-LIGHT® brand UV modules (MacDermid Graphic Arts, Atlanta, Georgia), as well as those manufactured by Anderson & Vreeland (Bryan, OH) and Photomeca (Pompeii, France). For certain applications, it may be desirable to combine the printing and exposing functions in a single device. It also may be desirable to "back" expose the photocurable elements by exposing the support layers thereof elements to actinic radiation for a time and under conditions effective to cure a portion of the photocurable material in the region adjacent the support. This back exposure can be performed after the mounting step (provided that the carrier sheet and the mounting means are sufficiently transparent to actinic radiation), but more preferably is performed before the photocurable elements have been mounted.

Following front exposure of the negative image to actinic radiation, uncured photopolymer is removed from the mounted photocurable elements, typically by washing the elements with (and/or in) an organic and/or aqueous solvent in which the photocurable material is at least somewhat soluble. This solvent wash step typically is accompanied or preceded by brushing, wiping, or some other mild, non-destructive abrasion of the elements. Useful washing devices include those commercially available from MacDermid Graphic Arts, Anderson & Vreeland, and Photomeca.

Additional objects, advantages, and novel features of this invention will become apparent to those skilled in the art upon examination of the following examples thereof on effect of ink jet imaging on photopolymer plates as a function of time and barrier layer thickness, which are not intended to be limiting.

### EXAMPLES

### Example 1

### Establishing a Baseline

The present invention can be used with any commercially available photocurable element used to make a flexographic printing plate such as, for example, FLEX-LIGHT® FLEXCOR®, and FLEX-LIGHT SPLASH®, commercially available from MacDermid Graphic Arts, Atlanta, Georgia. For this study, however, FLEXCOR® photocurable elements were employed.

To establish a baseline, two FLEXCOR® plates were back-exposed for 52 seconds on a FLEX-LIGHT® model 5280 exposure unit (MacDermid Graphic Arts, Atlanta, Georgia). The coversheet was then removed from the element, which was then placed on a BOXCOR® unit (MacDermid Graphic Arts, Atlanta, Georgia). After ink-jet printing of a negative image directly on the surface of the photocurable elements, one element was immediately given a face exposure, on the printed surface, for 10 minutes in the exposure unit. The other element was given the same face exposure two hours after the ink-jet printing. The exposed elements were then processed through a FLEX-LIGHT® 5280; Serial No. 017 in-line processor using SOLVIT® brand developing solvent (MacDermid Graphic Arts, Atlanta, Georgia) for 10 minutes to remove the uncured polymer. The sample plates were then dried, post-exposed and detackified in a FLEX-LIGHT® 5280, Serial No. 017 dryer and finishing unit. The finished plates thus obtained had a relief of about 45 mils. The detail held on the finished plates are readily observable with the naked eye.

As illustrated in Table 1, the plates exhibited significant differences in print quality. The plate exposed immediately after the ink deposit held good detail down to 5% on 55 lines per inch screen dots. The plate exposed 2 hours after the ink was deposited only held good detail down to 40% on 55 lines per inch screen dots.

**TABLE 1:**

| **BASELINE - NO SLIP FILM** | | | |
|---|---|---|---|
| Slip Film Type | Slip Film Thickness | Dwell Time on Plate Before Exposure | Halftone Screen Held @ 55 lpi |
| N/A | N/A | 0 hours | 5% |
| N/A | N/A | 2 hours | 40% |

### Example 2

### Traditional Slip Films

A. As a comparative example, the procedure of Part I was substantially repeated, except that the surface of the photocurable element was coated with a 0.1 mil layer of MACROMELT® 9600 polyamide (Henkel Corp., Minneapolis, MN). The first plate was exposed immediately after the ink was deposited and the other was exposed after a 1.5 hour delay. The detail held on the finished plates are readily observable with the naked eye.
   As illustrated in Table 2, the plates exhibited significant differences in print quality. The plate exposed immediately after the ink deposit held good detail down to 5% on 55 lines per inch screen dots. The plate exposed 1.5 hours after the ink was deposited only held good detail down to 20% on 55 lines per inch screen dots.
B. As another comparative example, the procedure of Part I was substantially repeated for two photocurable printing elements, except that the surface of the photocurable element was coated with a 0.4 mil layer of MACROMELT® 9600 polyamide (Henkel Corp., Minneapolis, MN) and the other element with a 1 mil layer of MACROMELT® 9600 polyamide. The detail held on the finished plates are readily observable with the naked eye.
   As illustrated in Table 2, the thickness of the conventional MACROMELT® 9600 slip film exhibited a slight differences in imaging quality. The plate having the 0.4 mil-thick layer of MACROMELT® 9600 polyamide held good detail down to 8% on 55 lines per inch screen dots after a delay of 1.5 hours between the ink deposit and exposure. The plate having the 1.0 mil-thick layer of MACROMELT® 9600 polyamide held good detail down to 5% on 55 lines per inch screen dots after a delay of 2 hours between the ink deposit and exposure.

**TABLE 2:**

| **TRADITIONAL SLIP FILM** | | | |
|---|---|---|---|
| Slip Film Type | Slip Film Thickness | Dell Time on Plate Before Exposure | Halftone Screen Held @ 55 lpi |
| Macromelt | .1 mil | 0 hours | 5% |
| Macromelt | .1 mil | 1.5 hours | 20% |
| Macromelt | .4 mil | 1.5 hours | 8% |
| Macromelt | 1 mil | 2 hours | 5% |

### Example 3

### Barrier Layers of the Invention

A. For this set of experiments, a 5-15% solution of Klucel® L hydroxypropylcellulose (Hercules Inc., Delaware, DE) was prepared by dissolving an appropriate amount of Klucel® L in a 2:1 isopropanol:water mixture. The Klucel® L solution also included 0.5% of an non-ionic surfactant.
   The procedure of Part I was substantially repeated, except that the surface of the photocurable element was coated with a 0.1 mil layer of Klucel® L hydroxypropylcellulose (Hercules Inc., Delaware, DE). The first plate was exposed immediately after the ink was deposited and the other was exposed after a 1.5 hour delay. The detail held on the finished plates are readily observable with the naked eye.
   As illustrated in Table 3, the plates exhibited significant differences in imaging quality. The plate exposed immediately after the ink deposit held good detail down to 2% on 55 lines per inch screen dots. The plate exposed 1.5 hours after the ink was deposited only held good detail down to 6% on 55 lines per inch screen dots.
B. The procedure of Part I was substantially repeated for two photocurable printing elements, except that the surface of the photocurable element was coated with a 0.4 mil layer of Klucel® L hydroxypropylcellulose (Hercules Inc., Delaware, DE) and the other element with a 1 mil layer of Klucel® L hydroxypropylcellulose. The detail held on the finished plates are readily observable with the naked eye.
   As illustrated in Table 3, the thickness of the Klucel® L hydroxypropylcellulose produced a more effective barrier layer at comparable thicknesses to the MACROMELT® 9600 polyamide barrier layer. For example, when ink was deposited on a photocurable element having a 0.1 mil-thick Klucel® L barrier layer for 1.5 hours, the resulting printing plate, after face exposure, was able to hold good detail down to 6% on 55 lines per inch screen dots. When ink was deposited on a photocurable element having a 0.4 mil-thick Klucel® L barrier layer for 1.5 hours, the resulting printing plate, after face exposure, was able to hold good detail down to 2% on 55 lines per inch screen dots. In contrast, referring to Table 2, when ink was deposited on a photocurable element having a 0.1 mil-thick MACROMELT® 9600 polyamide barrier layer for 1.5 hours, the resulting printing plate, after face exposure, was able to hold good detail down to only 20% on 55 lines per inch screen dots. When ink was deposited on a photocurable element having a 0.4 mil-thick MACROMELT® 9600 polyamide barrier layer for 1.5 hours, the resulting printing plate, after face exposure, was able to hold good detail down to 8% on 55 lines per inch screen dots. This result is significant in that, typically the thickness of the barrier layer will be directly proportional to the layer's barrier properties. However, in forming relief images on photocurable elements, it is preferable to keep the distance between the negative (ink jet mask) and the photopolymer at a minimum. If this gap is greater than 1 mil, image resolution is typically adversely effected. Thus, the above Examples show that a relatively thin barrier layer according to the present invention can be highly effective against ink (or components thereof) migration into the photopolymer which may adversely effect the quality of the relief image.

**TABLE 3:**

| **EXPERIMENTAL SLIP FILM** | | | |
|---|---|---|---|
| Slip Film Type | Slip Film Thickness | Dwell Time on Plate Before Exposure | Halftone Screen Held @ 55 lpi |
| Klucel | .1 mil | 0 hours | 2% |
| Klucel | .1 mil | 1.5 hours | 6% |
| Klucel | .4 mil | 1.5 hours | 2% |
| Klucel | 1 mil | 2 hours - 11 hours | 3% |

Those skilled in the art will appreciate that numerous changes and modifications may be made to the preferred embodiments of the invention and that such changes and modifications may be made without departing from the spirit of the invention. It is therefore intended that the appended claims cover all such equivalent variations as fall within the true spirit and scope of the invention.

## Claims

1. A method comprising depositing a negative-forming ink onto a first face of a photocurable element having first and second opposing major faces, said ink being substantially opaque to actinic radiation in at least one wavelength region effective to cure photocurable material within said element and substantially resistant to polymerization upon exposure to actinic radiation in said wavelength region, wherein said first face of said photocurable element includes a protective layer that is substantially impermeable with respect to said ink.

2. The method of claim 1 wherein said protective layer is hydrophilic.

3. The method of claim 2 wherein said hydrophillic layer comprises a polyvinyl alcohol, film-forming starch derivative, film-forming cellulose derivative, copolymer of acrylic acid and at least one other vinyl monomer, or a mixture thereof.

4. The method of claim 1 wherein said protective layer comprises a film-forming cellulose derivative.

5. The method of claim 4 wherein said film-forming cellulose derivative is carboxymethyl cellulose (CMC), methylcellulose (MC), hydroxyethyl cellulose (HEC), or hydroxypropyl cellulose (HPC).

6. The method of claim 5 wherein said protective layer comprises hydroxypropylcellulose.

7. The method according to any one of the preceding claims, wherein said photocurable material comprises an elastomer compound, an ethylenically unsaturated compound having at least one terminal ethylenic group, and a photoinitiator.

8. The method according to any one of the preceding claims, wherein said wavelength region is from about 300 to about 400 nm.

9. The method according to any one of the preceding claims, wherein said ink is ejected from an ink jet print head.

10. The method according to any one of the preceding claims further comprising disposing said second face of said photocurable element upon a portion of a carrier sheet.

11. The method according to any one of the preceding claims further comprising exposing said first face of said photocurable element to actinic radiation for a time and under conditions effective to cure said photocurable material.

12. The method of claim 11 further comprising removing uncured photocurable material from said photocurable element.

13. A photocurable element comprising:
a support layer;
photocurable material disposed upon said support layer;
a protective layer disposed upon said photocurable material; and
ink disposed upon said protective layer, said ink being substantially opaque to actinic radiation in at least one wavelength region effective to cure said photocurable material and substantially resistant to polymerization upon exposure to actinic radiation in said wavelength region, wherein said protective layer is substantially impermeable with respect to said ink.

14. The photocurable element of claim 13 wherein said support layer is a polyester film.

15. The photocurable element of claim 13 or 14, wherein said photocurable material comprises a plurality of layers.

16. The photocurable element of claim 13, 14 or 15, wherein said photocurable material comprises an elastomer compound, an ethylenically unsaturated compound having at least one terminal ethylenic group, and a photoinitiator.

17. The photocurable element of any one of claims 13 to 16, wherein said ink comprises 2, 2', 4, 4' - tetrahydroxybenzophenone.

18. The photocurable element of any one of claims 13 to 17, wherein said protective layer is hydrophilic.

19. The photocurable element of claim 18 wherein said protective layer comprises film-forming cellulose derivatives.

20. The photocurable element of any one of claims 13 to 17, wherein said protective layer comprises cellulose.

21. The photocurable element of any one of claims 13 to 17, wherein said protective layer comprises hydroxypropylcellulose.
